# EUROPÄISCHE PATENTSCHRIFT

(11) **EP 3 699 015 B1**
(45) Veröffentlichungstag und Bekanntmachung des Hinweises auf die Patenterteilung: **20.09.2023**
(21) Anmeldenummer: 20150840.5
(22) Anmeldetag: 09.01.2020
(51) Int. Cl.: G01R 31/327, H02H 3/33, H02H 3/16, H02H 3/347, B60L 3/00, B60L 3/04

(54) **ELEKTRISCHE SCHALTUNGSVORRICHTUNG ZUR ERKENNUNG EINES NICHTGEÖFFNETEN SCHALTKONTAKTES SOWIE EINER SCHUTZLEITERUNTERBRECHUNG IN EINER EIN- ODER MEHRPHASIGEN ELEKTRISCHEN ZULEITUNG**
ELECTRICAL SWITCHING DEVICE FOR DETECTING A NON-OPEN SWITCHING CONTACT AND A CIRCUIT BREAK IN A SINGLE OR MULTI-PHASE ELECTRIC SUPPLY
DISPOSITIF DE CIRCUIT ÉLECTRIQUE PERMETTANT DE DÉTECTER UN CONTACT DE COMMUTATION NON OUVERT AINSI QU'UNE INTERRUPTION DE CONDUCTEUR DE PROTECTION DANS UN CÂBLE D'ALIMENTATION ÉLECTRIQUE MONOPHASÉ OU MULTIPHASÉ

(30) Priorität: 23.01.2019 DE 102019101636
(43) Veröffentlichungstag der Anmeldung: 26.08.2020
(73) Patentinhaber: Bender GmbH & Co. KG, 35305 Grünberg (DE)
(72) Erfinder: MORICH, Lars, 65604 Elz (DE)
(74) Vertreter: advotec.

(56) Entgegenhaltungen:
- EP-A2- 2 571 128
- WO-A1-2012/104703
- WO-A2-2011/112510
- DE-A1-102009 034 887
- JP-A- 2015 154 641
- US-A1- 2011 122 536

## Beschreibung

Die Erfindung betrifft eine elektrische Schaltungsvorrichtung und ein Verfahren zur Erkennung eines nichtgeöffneten Schaltkontaktes sowie einer Schutzleiterunterbrechung in einer ein- oder mehrphasigen elektrischen Zuleitung.

Elektrische Zuleitungen, bestehend aus einem oder mehreren Phasenleitern und einem Neutralleiter als aktive Leiter sowie einem Schutzleiter, werden im Hinblick auf die elektrische Sicherheit oftmals mit Trennvorrichtungen versehen, um einen Verbraucher von der Netzinfrastruktur abzutrennen.

Diese Trennvorrichtungen weisen in der Regel Schaltkontakte (Relais) auf, die unter bestimmten Betriebsbedingungen, beispielsweise durch hohe Einschaltströme, dazu neigen, dass deren Kontakte nicht zuverlässig öffnen - "verkleben" können - und somit die Gefahr besteht, dass der Verbraucher nicht sicher von dem Netz getrennt wird.

So werden beispielsweise bei Ladekabeln für den Mode 2 - Lademodus und für Ladestationen Schaltkontakte verbaut, deren funktionsgemäße Öffnung überwacht werden muss. Bei mehrphasigen Zuleitungen ist diese Überwachung für jeden Phasenleiter (Phase) durchzuführen.

Eine weitere Fehlerquelle stellt die Unterbrechung der Schutzleiterverbindung dar. In diesem Fall kann eine installierte Fehlerstrom-Schutzeinrichtung (RCD), insbesondere bei der Ladung eines Elektrofahrzeuges, nicht mehr eine hinreichende elektrische Sicherheit bieten. Die Überwachung einer intakten Schutzleiterverbindung ist daher dringend empfohlen.

Aus dem Stand der Technik ist es bekannt, zur Überwachung einer ordnungsgemäßen Öffnung von Schaltkontakten in dem elektrischen Gesamtsystem für jede Phase ein oder mehrere galvanisch getrennte Prüfsysteme zu verbauen, die die Netzspannung detektieren und über eine Auswertelogik das Ergebnis an eine übergeordnete Systemsteuerung weiterleiten. Allerdings sind der Bauteileaufwand, der Platz- und Strombedarf sowie der Verdrahtungsaufwand und die Kosten dafür erheblich. Auch stellen Hilfsrelais für jede Phase an einer Hutschiene eine sehr aufwendige alternative Lösung dar.

Die Offenlegungsschrift DE 10 2009 034887 A1 zeigt eine Ladestation mit einer digitalen Sicherungs- und Überwachungseinrichtung zur Bereitstellung elektrischer Energie für ein Elektrofahrzeug. Die Sicherungs- und Überwachungseinrichtung weist Sensormittel zur Erfassung mindestens einer elektrischen Größe im Ladestromkreis auf und leitet diese Größe(n) an eine Auswerteeinrichtung weiter, welche ein sicherheitsrelevantes Auslösekriterium eine Schalteinrichtung zum gesteuerten Ein- und Ausschalten des Ladestromkreises ansteuert Die digitale Sicherungs- und Überwachungseinrichtung 50 ist weiter in der Lage, einen Fehlerstrom zu simulieren, um die Funktion eines RCDs zu prüfen.

Weitere Maßnahmen, die zu einer erhöhten Sicherheit des elektrischen Systems durch eine kontinuierliche Schutzleiterüberwachung führen, werden zurzeit nicht in Ladesystemen eingesetzt.

Der vorliegenden Erfindung liegt somit die Aufgabe zugrunde, technische Maßnahmen zu ergreifen, die eine funktionsgemäße Öffnung eines Schaltkontaktes sowie eine Schutzleiterverbindung zuverlässig überwachen.

Diese Aufgabe wird mit den Merkmalen gemäß Patentanspruch 1 gelöst durch eine elektrische Schaltungsvorrichtung zur Erkennung eines nicht-geöffneten Schaltkontaktes sowie einer Schutzleiterunterbrechung in einer ein oder mehrphasigen elektrischen Zuleitung mit aktiven Leitern und einem Schutzleiter.

Aus dem Stand der Technik ist es bekannt, zur Überwachung von Fehlerströmen, die beispielsweise durch einen Erdschluss verursacht werden, ein Differenzstrom-Überwachungsmodul (RCMB) einzusetzen, welches eine Steuerung (RCMB-Steuerung) zum Auswerten eines von einem Messstromwandler gelieferten Messsignals und zum Erzeugen eines (ersten) Abschaltsignals aufweist. Der Messstromwandler erfasst dabei einen auf der Zuleitung als Differenzstrom in Erscheinung tretenden Fehlerstrom.

Weiterhin ist es bekannt, das Differenzstrom-Überwachungsmodul mit einer Abschalteinrichtung zu koppeln, die eine Trennung der aktiven Leiter der Zuleitung bewirkt.

Auch kann in bekannter Weise eine übergeordnete Systemsteuerung vorhanden sein, die alternativ oder zusätzlich zu dem Differenzstrom-überwachungsmodul ein zweites Abschaltsignal an die Abschalteinrichtung weitergibt. Die übergeordnete Systemsteuerung wird über ein Fehlersignal von der Steuerung des Differenzstrom-Überwachungsmoduls über das Auftreten eines Fehlerstroms informiert.

Erfindungsgemäß wird die Steuerung des Differenzstrom-Überwachungsmoduls (RCMB-Steuerung) dahingehend erweitert, dass sie eine Fehlerstrom-Steuereinheit zur Erzeugung eines Steuersignal-Musters aufweist. Das Steuersignal-Muster besteht aus einer Abfolge von Einschaltimpulsen, die an eine erste elektronische Schalteinheit weitergeleitet werden, um einen möglichen künstlichen, passiven Fehlerstrom auf einem oder mehreren der aktiven Phasenleiter und dem Schutzleiter (als Rückleiter) anzuregen, wobei dieser Fehlerstrom im Fall eines nicht geöffneten, zu prüfenden Schaltkontaktes und eines intakten Schutzleiters in einem geschlossenen Stromkreises dann auch tatsächlich fließt und erkannt sowie ausgewertet werden kann. Gemäß dem in der RCMB-Steuerung vorgegebenen Steuersignal-Muster wird also ein zeitliches Muster von ein-/ausgeschalteten Fehlerstromverläufen auf der elektrischen Zuleitung erzeugt, welches wiederum von dem Messstromwandler erfasst und in der RCMB-Steuerung ausgewertet wird.

Durch während der Überwachung variierende Steuersignal-Muster ist eine zuverlässige Detektion des künstlichen, passiven Fehlerstroms auch bei hohen dynamischen Störpegeln während des laufenden Betriebs der zu überwachenden elektrischen Anlage (Zuleitung) gewährleistet.

Erfindungsgemäß wird die Amplitude des geschalteten künstlichen passiven Fehlerstroms derart eingestellt, dass dieser als Differenzstrom von dem Differenzstrom-Überwachungsmodul, genauer von der RCMB-Steuerung des Differenzstromüberwachungsmoduls, detektierbar ist, nicht aber zu einem Ansprechen einer in der elektrischen Zuleitung installierten Fehlerstromschutzeinrichtung (RCD) führt.

Die Höhe des künstlichen, passiven Fehlerstroms liegt vorzugsweise in der Größenordnung zwischen 200µA und 3500 µA und somit unterhalb des Ansprechwertes (Auslöseschwelle) einer Fehlerstrom-Schutzeinrichtung (RCD). Diese Größenordnung liegt damit auch unter einem erlaubten Schutzleiterstrom und unter einem erlaubten Berührungsstrom.

Wird ein derartiger künstlicher, passiver Fehlerstrom detektiert, so gilt dies als Anzeichen dafür, dass ein funktionsfähiger Schutzleiter vorhanden ist und eine Netzspannung an dem jeweiligen aktiven Leiter anliegt, somit der zu überwachende Schaltkontakt sich in geschlossenem Zustand befindet und der Schutzleiter intakt ist. Das Vorhandensein des intakten Schutzleiters und der Netzspannung wird durch eine Signalisierungseinrichtung mitgeteilt.

Insoweit kann je nach Zielrichtung der Überwachungsaufgabe festgestellt werden, ob der zu überwachende Schaltkontakt tatsächlich funktionsgemäß geöffnet ist und daher kein Fehlerstrom fließen sollte, oder, falls der Schaltkontakt betriebsbedingt geschlossen sein soll, ob der Schutzleiter unterbrochen ist.

Die Erfindung führt somit durch die vorgeschlagene Überwachung zu einer Erhöhung der elektrischen Sicherheit und ermöglicht es, die Anzahl und Kosten der Bauelemente sowie den erforderlichen Bauraum und den Stromverbrauch zu reduzieren.

Die RCMB-Steuerung weist einen Fehlerstrom-Vergleicher auf, der einen von dem Messstromwandler erfassten Fehlerstromverlauf mit dem aufgrund des Steuersignalmusters erwarteten Fehlerstromverlauf vergleicht, um den geschalteten, künstlichen, passiven Fehlerstrom sicher zu detektieren.

Indem von der RCMB-Steuerung mittels des Steuersignal-Musters ein Ein-/Ausschaltmuster für den zu schalteten Fehlerstrom vorgegeben wird, kann der künstliche Fehlerstrom sicher von tatsächlichen, unbeabsichtigt auftretenden Fehlerströmen oder anderen Störeinflüssen zuverlässig unterschieden werden. Nur wenn der erfasste Fehlerstromverlauf mit dem aufgrund des Steuersignal-Musters erwarteten Fehlerstromverlauf übereinstimmt, wird der erfasste Fehlerstrom als Anzeichen für das Vorliegen einer Spannung und damit für einen geschlossenen Schaltkontakt und einen intakten Schutzleiter gewertet.

In weiteren vorteilhaften Ausgestaltungen ist die Fehlerstrom-Steuereinheit zum Erzeugen eines ersten Steuersignals an eine zweite elektronische Schalteinheit ausgelegt, um einen künstlichen Auslösestrom zum Auslösen der Fehlerstrom-Schutzeinrichtung zu schalten und/oder die Systemsteuerung ist zum Erzeugen eines zweiten Steuersignals an die zweite elektronische Schalteinheit ausgelegt, um einen künstlichen Auslösestrom zum Auslösen der Fehlerstromschutzeinrichtung zu schalten.

Um eine in der Zuleitung installierte Fehlerstrom-Schutzeinrichtung zum Auslösen zu zwingen, und damit den Verbraucher von der Netzinfrastruktur zu trennen, wird von der Fehlerstrom-Steuereinheit oder von der Systemsteuerung ein künstlicher Auslösestrom generiert, der zum Auslösen dieser Fehlerstrom-Schutzeinrichtung führt.

Damit kann im Hinblick auf die Erkennung einer Schutzleiterunterbrechung eine sichere Trennung der Zuleitung bzw. eine Abschaltung angeschlossener Verbraucher von dem Gesamtsystem ohne weitere Abschaltvorrichtungen gewährleistet werden.

Mit Vorteil weist die erste elektronische Schalteinheit drei elektronische Schalter auf, wobei jedem der drei aktiven Phasenleiter ein elektronischer Schalter zugeordnet ist, um getrennt für jeden der drei aktiven Phasenleiter einen künstlichen, passiven Fehlerstrom zu schalten.

In dieser Ausgestaltung wird im Fall einer 3-phasigen Zuleitung für jeden aktiven Phasenleiter ein eigener, getrennter Fehlerstrom geschaltet, der von dem Messstromwandler erkannt und von der RCMB-Steuerung ausgewertet wird. Die Information kann in Form eines Fehlersignals an eine übergeordnete Systemsteuerung weitergegeben werden.

Vorteilhaft weist die RCMB-Steuerung eine Messeinrichtung zur Netzfrequenzmessung und/oder zur Drehfeldrichtungserkennung mittels geeigneter Steuersignal-Muster auf den aktiven Phasenleitern auf.

Durch die Verwendung eines für jeden der aktiven Phasenleiter unterschiedlichen Steuersignal-Musters kann eine Netzfrequenzmessung und/oder eine Drehfeldrichtungserkennung durchgeführt werden.

Alternativ zu der getrennten Schaltung der künstlichen, passiven Fehlerströme für jeden der drei aktiven Phasenleiter weist die erste elektronische Schalteinheit genau einen elektronischen Schalter auf, der bei einer 3-phasigen Zuleitung für die drei aktiven Phasenleiter einen gemeinsamen künstlichen, passiven Fehlerstrom schaltet. In dieser Ausgestaltung werden alle drei aktiven Phasenleiter derart berücksichtigt, dass der mögliche Fehlerstrom gleichzeitig über alle drei aktiven Phasenleiter fließt.

Die der Erfindung zugrundeliegende Aufgabe wird weiter gelöst mit den Merkmalen des Anspruchs 7 durch ein erfindungsgemäßes Verfahren zur Erkennung eines nichtgeöffneten Schaltkontaktes sowie einer Schutzleiterunterbrechung in einer ein oder mehrphasigen elektrischen Zuleitung mit aktiven Leitern und einem Schutzleiter.

Das erfindungsgemäße Verfahren bildet die Grundlage für die vorgenannte Realisierung mittels der erfindungsgemäßen elektrischen Schaltvorrichtung.

Insoweit treffen auch die genannten Vorteile und technischen Wirkungen in gleicher Weise für das erfindungsgemäße Verfahren zu.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern. Es zeigen:
**Fig. 1****:** Elektrische Schutzeinrichtungen nach dem Stand der Technik für eine elektrische Zuleitung,
**Fig. 2****:** eine erfindungsgemäße elektrische Schaltungsvorrichtung für einen Phasenleiter,
**Fig. 3****:** eine erfindungsgemäße elektrische Schaltungsvorrichtung für Dreiphasenleiter,
**Fig. 4****:** eine erfindungsgemäße elektrische Schaltungsvorrichtung für Dreiphasenleiter (Variante),
**Fig. 5****:** eine erfindungsgemäße elektrische Schaltungsvorrichtung gemäß Fig. 4 mit zweiter elektronischer Schalteinheit und
**Fig. 6****:** einen zeitlichen Verlauf eines künstlichen, passiven Fehlerstroms.

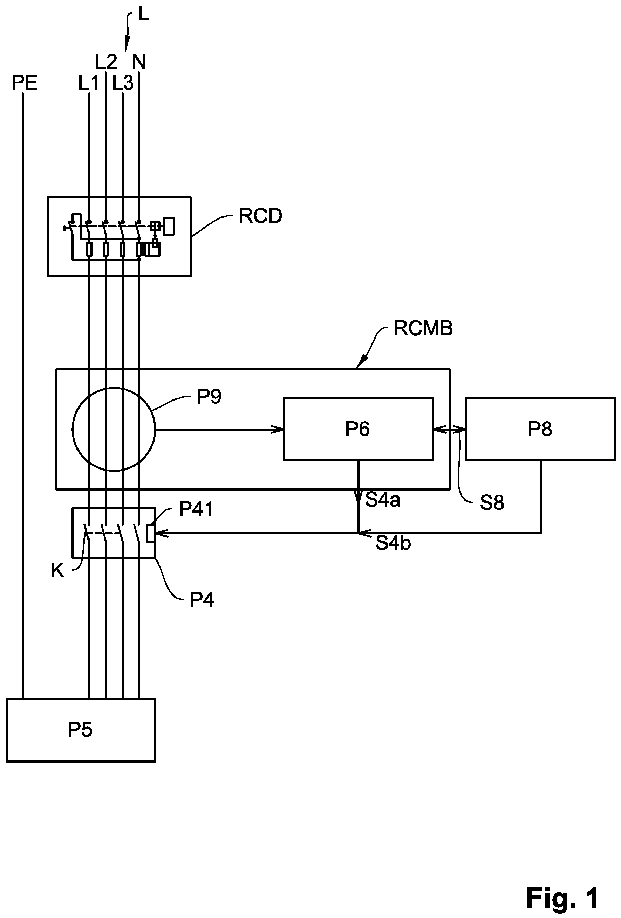

**Fig. 1** zeigt elektrische Schutzeinrichtungen nach dem Stand der Technik für eine dreiphasige elektrische Zuleitung L und entspricht im Wesentlichen einer Standardkonfiguration für die Überwachung mit einem modularen Differenzstrom-Überwachungsgerät (Differenzstrom-Überwachungsmodul RCMB).

Die Zuleitung L umfasst drei Phasenleiter L1, L2, L3 und einen Neutralleiter N als aktive Leiter sowie einen Schutzleiter PE. Weiterhin ist die Zuleitung L mit einer Fehlerstrom-Schutzeinrichtung RCD abgesichert, welche einen Verbraucher P5 von der Stromversorgung trennt, falls ein Fehlerstrom den Ansprechwert der Fehlerstrom-Schutzeinrichtung RCD überschreitet, wobei der Ansprechwert (Bemessungsfehlerstrom) in der Regel oberhalb von 6 mA liegt.

Zwischen die Fehlerstromschutzeinrichtung RCD und dem Verbraucher P5 sind das Differenzstrom-Überwachungsmodul RCMB und eine Abschalteinrichtung P4 geschaltet.

Das Differenzstrom-Überwachungsmodul RCMB umfasst einen Messstromwandler P9, der einen Differenzstrom auf der Zuleitung L erfasst und ein Messsignal zur Auswertung an die RCMB-Steuerung P6 weiterleitet. Das Auswerteergebnis wird in Form eines Fehlersignals S8 an eine übergeordnete Systemsteuerung P8 weitergeleitet. Sowohl die RCMB-Steuerung P6 als auch die Systemsteuerung P8 erzeugen jeweils ein Abschaltsignal S4a, S4b, welches die Abschalteinrichtung P4 ansteuert, die die Zuleitung L trennt.

Die Abschalteinrichtung P4 weist Schaltkontakte K auf, die zum Trennen der Zuleitung L dienen und deren funktionsgemäßes Öffnungsverhalten zu überwachen ist.

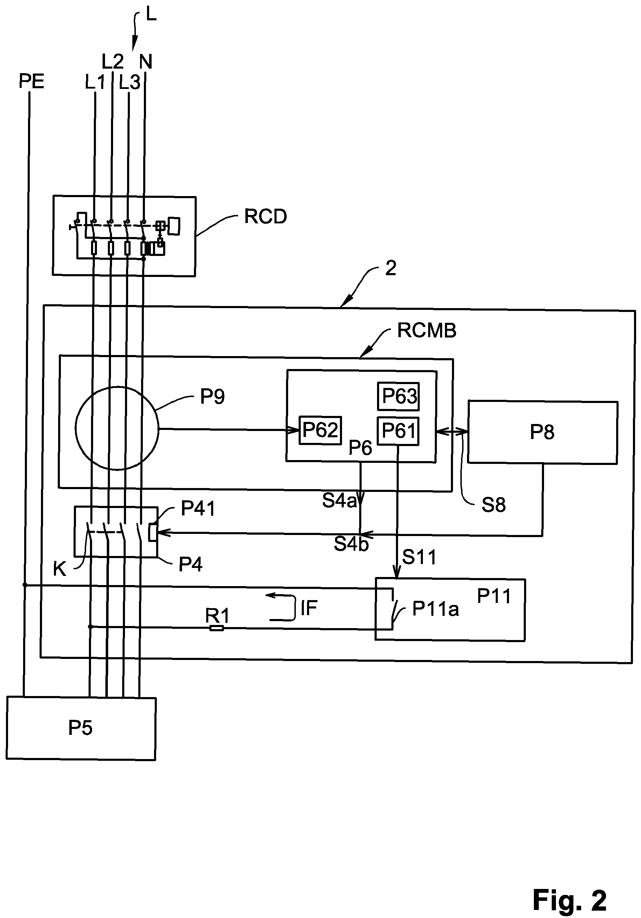

**Fig. 2** zeigt eine erfindungsgemäße elektrische Schaltungsvorrichtung 2 für einen Phasenleiter L1 der Zuleitung L.

Dargestellt ist eine Anordnung mit einer 3-phasigen Zuleitung L, jedoch ist die elektrische Schaltungsvorrichtung 2 in analoger Weise auch in einer einphasigen Zuleitung L zur Erkennung eines nicht-geöffneten Schaltkontaktes K einer Abschalteinrichtung P4 sowie zur Erkennung einer Schutzleiterunterbrechung einsetzbar.

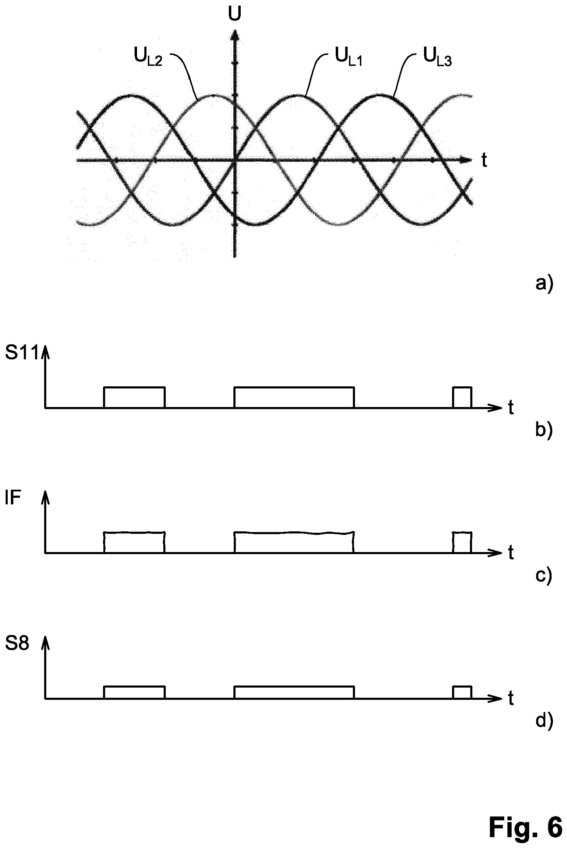

Erfindungsgemäß ist die RCMB-Steuerung P6 mit einer Fehlerstrom-Steuereinheit P61 erweitert, welche ein Steuersignal-Muster S11 erzeugt, das eine erste elektronische Schalteinheit P11 ansteuert. Entsprechend dem übermittelten Steuersignal-Muster S11 schaltet die erste elektronische Schalteinheit P11 über einen strombegrenzenden Widerstand R1 mittels eines Schalters Plla einen Fehlerstrom IF ein, der über den Phasenleiter L1 und den Schutzleiter PE fließt. Dieser Fehlerstrom IF wird von dem Messstromwandler P9 erfasst und in der RCMB-Steuerung P6 ausgewertet. Das von der Fehlerstrom-Steuereinheit P61 erzeugte Steuersignal-Muster veranlasst die erste elektronische Schalteinheit P11, den Fehlerstrom IF entsprechend dem vorgegebenen Steuersignal-Muster S11 ein- und auszuschalten. Wird ein diesem Steuersignal-Muster S11 entsprechender Fehlerstrom IF von dem Messstromwandler P9 erfasst und stellt ein Fehlerstrom-Vergleicher P62 fest, dass dieser erfasste Fehlerstrom IF dem erzeugten Steuersignalmuster S11 entspricht, so gilt der Fehlerstrom IF als erkannt. Dies wiederum gilt als Anzeichen dafür, dass auf dem Leiter L1 eine Phasenleiterspannung (Netzspannung) UL1 (Fig. 6) vorherrscht, somit der zu überprüfende Schaltkontakt K der Abschalteinrichtung P4 (noch) geschlossen ist. Soll der entsprechende Schaltkontakt K betriebsbedingt geöffnet sein, so ist hiermit ein nicht funktionsgemäßes (Öffnungs-)Verhalten dieses Schaltkontaktes K erkannt. Soll der Schaltkontakt K hingegen betriebsbedingt geschlossen sein, so kann die Erkennung des Fehlerstroms - gleichbedeutend mit dem Vorhandensein einer Netzspannung - dahingehend interpretiert werden, dass eine intakte Schutzleiterverbindung PE vorliegt.

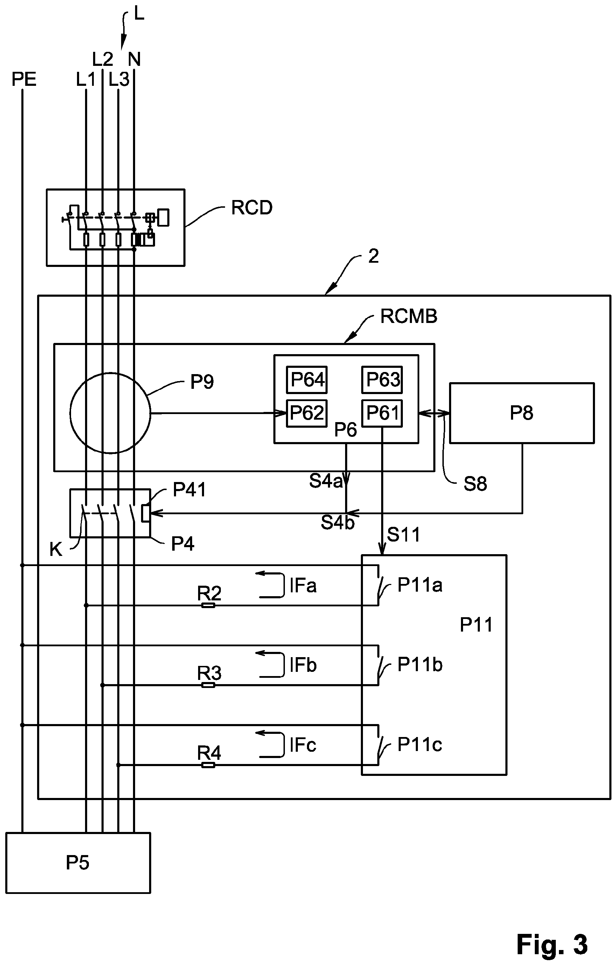

In Fig. 3 ist eine erfindungsgemäße elektrische Schaltungsvorrichtung 2 für eine dreiphasige Zuleitung L dargestellt.

In Erweiterung der erfindungsgemäßen Schaltungsvorrichtung 2 aus Fig. 2 ist die erste elektronische Schalteinheit P11 dahingehend ergänzt worden, dass sie drei elektronische Schalter Plla, P11b, Pllc aufweist, wobei jedem der drei aktiven Phasenleiter L1, L2, L3 der jeweilige Schalter P11a, P11b, Pllc zugeordnet ist, um über die jeweiligen strombegrenzenden Widerstände R2, R3, R4 getrennt für jeden der drei aktiven Phasenleiter L1, L2, L3 einen künstlichen, passiven Fehlerstrom IFa, IFb, IFc zu schalten.

Diese Ausgestaltung ermöglicht auch eine individuelle Erzeugung eines Steuersignal-Musters S11 und damit einen individuell fließenden Fehlerstrom für jeden aktiven Phasenleiter L1, L2, L3. Zusätzlich kann damit unter Verwendung geeigneter Steuersignal-Muster S11 auf den jeweiligen Phasenleitern L1, L2, L3 eine Frequenzmessung und/oder eine Drehfeldrichtungserkennung durchgeführt werden.

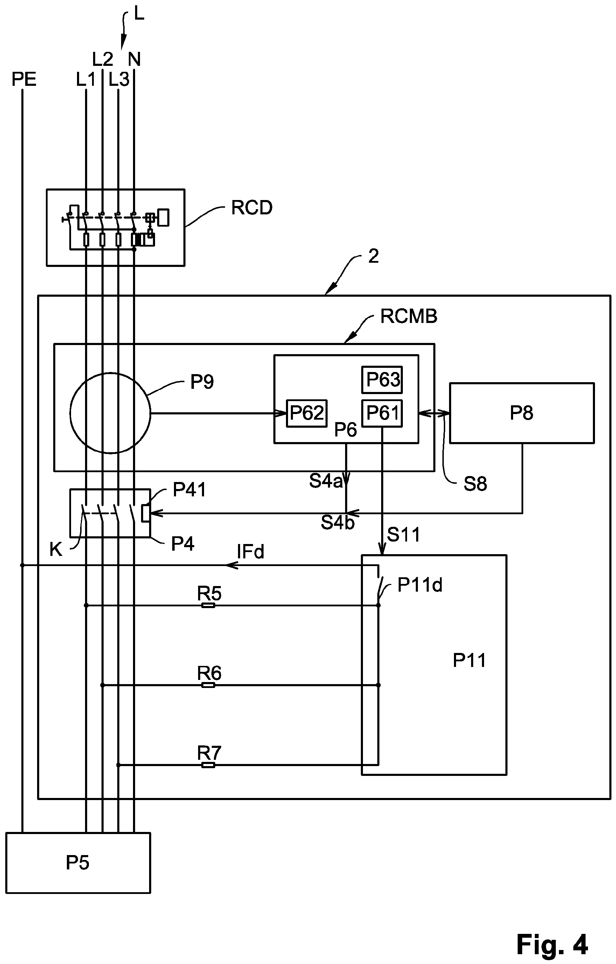

Die Fig. 4 zeigt eine erfindungsgemäße elektrische Schaltungsvorrichtung 2 für die Dreiphasen-Zuleitung L in einer Variante.

Dabei ist ausgehend von der Ausgestaltung nach Fig. 3 die erste elektronische Schalteinheit P11 dahingehend vereinfacht worden, dass diese nur einen Schalter P11d aufweist, der über die jeweiligen strombegrenzenden Widerstände R5, R6, R7 einen für alle aktiven Phasenleiter L1, L2, L3 fließenden Fehlerstrom IFd gleichzeitig schaltet.

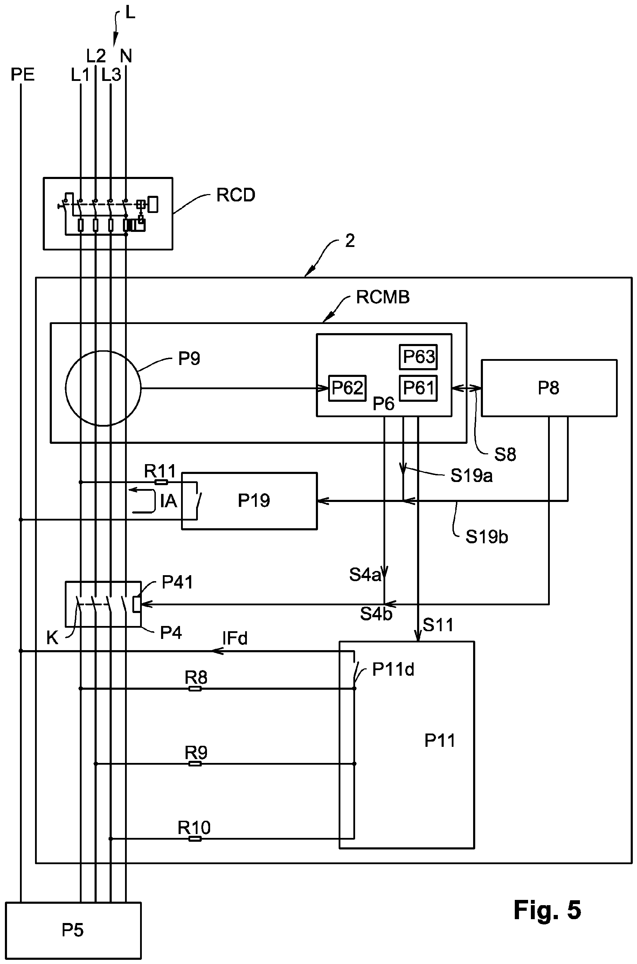

**Fig. 5** zeigt eine erfindungsgemäße elektrische Schaltungsvorrichtung für die Dreiphasen-Zuleitung L gemäß der Variante nach Fig. 4 erweitert um eine zweite elektronische Schalteinheit P19.

Die zweite elektronische Schalteinheit P19 empfängt ein erstes Steuersignal S19a von der Fehlerstromsteuereinheit P61 und/oder ein zweites Steuersignal S19b von der Systemsteuerung P8, um einen Auslösestrom IA über einen strombegrenzenden Widerstand R11 zu schalten. Dieser Auslösestrom IA ist im Gegensatz zu dem in der ersten elektronischen Schalteinheit P11 über die strombegrenzenden Widerstände R8, R9, R10 geschalteten Fehlerstrom IFd deutlich höher, sodass er zum Auslösen der Fehlerstrom-Schutzeinrichtung RCD führt. Unter der Voraussetzung, dass zuvor ein funktionsfähiger Schutzleiter PE erkannt wurde, kann so eine sichere Trennung der Zuleitung L bewirkt werden.

Ebenso wie die Variante nach Fig. 4 kann auch die Anordnung mit individueller Erzeugung des Steuersignal-Musters S11 nach Fig. 3 entsprechend mit der zweiten elektronischen Schalteinheit P19 erweitert werden.

Auch kann diese Erweiterung mit der zweiten elektronischen Schalteinheit P19 in Verbindung mit einer einphasigen Zuleitung L Verwendung finden.

**Fig. 6** zeigt schematisch die Erzeugung des künstlichen, passiven Fehlerstroms IF.

Teil a der Fig. 6 zeigt den Verlauf der Phasenleiterspannungen UL1, UL2, UL3. In Teil b ist der zeitliche Verlauf eines von der Fehlerstromsteuereinheit P61 der RCMB-Steuerung P6 erzeugten Steuersignalmusters S11 dargestellt. Einen diesem Rechteckmuster S11 entsprechender Verlauf des geschalteten Fehlerstroms IF zeigt Teil c der Fig. 6. Mittels des Messstromwandlers P9 wird dieser Fehlerstrom IF erfasst und in der RCMB-Steuerung P6 mit dem Fehlerstromvergleicher P62 ausgewertet, wobei ein entsprechendes Fehlersignal S8 generiert wird. Korreliert dieses Fehlersignal S8 - insbesondere hinsichtlich seines zeitlichen Verlaufs - mit dem Steuersignal-Muster S11, wie durch Vergleich der Darstellung in Teil b und Teil c der Fig. 6 leicht einsehbar ist, so kann davon ausgegangen werden, dass der absichtlich erzeugte, künstliche, passive Fehlerstrom IF auch tatsächlich fließt. Damit kann einerseits nachgewiesen werden, dass der zu überprüfende Schaltkontakt K noch geschlossen ist und dass der Schutzleiter PE funktionstüchtig ist.

## Patentansprüche

1. Elektrische Schaltungsvorrichtung (2) zur Erkennung eines nicht-geöffneten Schaltkontaktes (K) einer Abschalteinrichtung (P4) sowie zur Erkennung einer Schutzleiterunterbrechung in einer ein- oder mehrphasigen elektrischen Zuleitung (L) mit aktiven Leitern (L1, L2, L3, N) und einem Schutzleiter (PE),
mit einem Differenzstrom-Überwachungsmodul (RCMB), welches eine RCMB-Steuerung (P6) zum Auswerten eines von einem Messstromwandler (P9) gelieferten Messsignals und zum Erzeugen eines ersten Abschaltsignals (S4a) aufweist, wobei der Messstromwandler (P9) einen auf der Zuleitung (L) fließenden Differenzstrom erfasst, und mit einer Systemsteuerung (P8) zum Erzeugen eines zweiten Abschaltsignals (S4b),
wobei die Abschalteinrichtung (P4) zur Trennung der aktiven Leiter (L1, L2, L3, N) ausgelegt ist und einen Signaleingang (P41) zum Empfang des ersten Abschaltsignals (S4a) und des zweiten Abschaltsignals (S4b) aufweist und wobei die Systemsteuerung (P8) zum Empfang eines Fehlersignals (S8) mit der RCMB-Steuerung (P6) des Differenzstrom-Überwachungsmoduls (RCMB) verbunden ist.
**dadurch gekennzeichnet,**
**dass** die RCMB-Steuerung (P6) eine Fehlerstrom-Steuereinheit (P61) zur Erzeugung eines Steuersignal-Musters (S11) aufweist, welches eine erste elektronische Schalteinheit (P11) zum Schalten eines künstlichen, passiven Fehlerstroms (IF) ansteuert, der über einen oder mehrere der aktiven Leiter (L1, L2, L3, N) und den Schutzleiter (PE) fließt,
wobei der geschaltete, künstliche, passive Fehlerstrom (IF) so einstellbar ist, dass dieser als Differenzstrom von dem Differenzstrom-Überwachungsmodul (RCMB) detektierbar ist, aber nicht zu einem Ansprechen einer in der Zuleitung (L) installierbaren Fehlerstrom-Schutzeinrichtung (RCD) führt,
wobei die RCMB-Steuerung (P6) eine Signalisierungseinrichtung (P63) aufweist, die eine Detektion des künstlichen, passiven Fehlerstroms (IF) und damit das Vorhandensein des funktionsfähigen Schutzleiters (PE) sowie einer Netzspannung (UL1, UL2, UL3) signalisiert und
wobei die RCMB-Steuerung (P6) einen Fehlerstrom-Vergleicher (P62) aufweist, der einen von dem Messstromwandler (P9) erfassten Fehlerstromverlauf mit dem aufgrund des Steuersignal-Musters (S11) erwarteten Fehlerstromverlauf vergleicht, um den geschalteten, künstlichen, passiven Fehlerstrom (IF) sicher zu detektieren.

2. Elektrische Schaltungsvorrichtung (2) nach Anspruch 1,
**dadurch gekennzeichnet,**
**dass** die Fehlerstrom-Steuereinheit (P61) ausgelegt ist zum Erzeugen eines ersten Steuersignals (S19a) an eine zweite elektronische Schalteinheit (P19), um einen künstlichen Auslösestrom (IA) zum Auslösen der Fehlerstrom-Schutzeinrichtung (RCD) zu schalten, sofern zuvor der funktionsfähige Schutzleiter (PE) erkannt wurde.

3. Elektrische Schaltungsvorrichtung (2) nach einem der Ansprüche 1 oder 2,
**gekennzeichnet durch**
die Systemsteuerung (P8) ausgelegt ist zum Erzeugen eines zweiten Steuersignals (S19b) an eine/die zweite elektronische Schalteinheit (P19), um einen/den künstlichen Auslösestrom (IA) zum Auslösen der Fehlerstrom-Schutzeinrichtung (RCD) zu schalten.

4. Elektrische Schaltungsvorrichtung (2) nach einem der Ansprüche 1 bis 3,
**dadurch gekennzeichnet,**
**dass** die erste elektronische Schalteinheit (P11) im Fall einer 3-phasigen Zuleitung (L) drei elektronische Schalter (P11a, P11b, P11c) aufweist, wobei jedem der drei aktiven Phasenleiter (L1, L2, L3) ein elektronischer Schalter (P11a, P11b, P11c) zugeordnet ist, um getrennt für jeden der drei aktiven Phasenleiter (L1, L2, L3) einen künstlichen, passiven Fehlerstrom (IFa, IFb, IFc) zu schalten.

5. Elektrische Schaltungsvorrichtung (2) nach Anspruch 4,
**dadurch gekennzeichnet,**
**dass** die RCMB-Steuerung (P6) eine Messeinrichtung (P64) zur Netzfrequenzmessung und/oder zur Drehfeldrichtungserkennung mittels geeigneter Steuersignal-Muster (S11) auf den aktiven Phasenleitern (L1, L2, L3) aufweist.

6. Elektrische Schaltungsvorrichtung (2) nach einem der Ansprüche 1 bis 3,
**dadurch gekennzeichnet,**
**dass** die erste elektronische Schalteinheit (P 11) im Fall einer 3-phasigen Zuleitung (L) einen elektronischen Schalter (P11d) aufweist, der für die drei aktiven Phasenleiter (L1, L2, L3) einen gemeinsamen, künstlichen, passiven Fehlerstrom (IFd) schaltet.

7. Verfahren zur Erkennung eines nicht-geöffneten Schaltkontaktes (K) einer Abschalteinrichtung (P4) sowie zur Erkennung einer Schutzleiterunterbrechung in einer ein- oder mehrphasigen elektrischen Zuleitung (L) mit aktiven Leitern (L1, L2, L3, N) und einem Schutzleiter (PE),
wobei die Zuleitung mit einem Differenzstrom-Überwachungsmodul (RCMB) ausgestattet ist, welches eine RCMB-Steuerung (P6) zum Auswerten eines von einem Messstromwandler (P9) gelieferten Messsignals und zum Erzeugen eines ersten Abschaltsignals (S4a) aufweist, wobei der Messstromwandler (P9) einen auf der Zuleitung (L) fließenden Differenzstrom erfasst, und die Zuleitung mit der Abschalteinrichtung (P4) zur Trennung der aktiven Leiter (L1, L2, L3, N) und mit einer Systemsteuerung (P8) zum Erzeugen eines zweiten Abschaltsignals (S4b) ausgestattet ist,
umfassend die Verfahrensschritte:
- Erzeugen eines Steuersignal-Musters (S11) in einer Fehlerstrom-Steuereinheit (P61) der RCMB-Steuerung (P6)
- Ansteuern einer ersten elektronischen Schalteinheit (P11) mit dem Steuersignal-Muster (S11) zum Schalten eines künstlichen, passiven Fehlerstroms (IF), der über einen oder mehrere der aktiven Leiter (L1, L2, L3, N) und den Schutzleiter (PE) fließt,
- Einstellen des geschalteten, künstlichen, passiven Fehlerstroms (IF) so, dass dieser als Differenzstrom von dem Differenzstrom-Überwachungsmodul (RCMB) detektierbar ist, aber nicht zu einem Ansprechen einer in der Zuleitung (L) installierbaren Fehlerstrom-Schutzeinrichtung (RCD) führt,
- Signalisieren eines detektierten künstlichen, passiven Fehlerstroms (IF),
- Vergleichen eines von dem Messstromwandler (P9) erfassten Fehlerstromverlaufs mit dem aufgrund des Steuersignal-Musters (S11) erwarteten Fehlerstromverlauf mittels eines Fehlerstrom-Vergleichers (P62) in der RCMB-Steuerung (P6), um den geschalteten, künstlichen, passiven Fehlerstrom (IF) sicher zu detektieren.

8. Verfahren nach Anspruch 7,
**gekennzeichnet durch**
Trennen der aktiven Leiter (L1, L2, L3, N) mittels der Abschalteinrichtung (P4) über das erste Abschaltsignal (S4a) oder das zweite Abschaltsignal (S4b), falls der künstliche, passive Fehlerstrom (IF) signalisiert wird.

9. Verfahren nach Anspruch 7 oder 8,
**gekennzeichnet durch**
Erzeugen eines ersten Steuersignals (S19a) an eine zweite elektronische Schalteinheit (P19) mittels der Fehlerstrom-Steuereinheit (P61), um einen künstlichen Auslösestrom (IA) zum Auslösen der Fehlerstrom-Schutzeinrichtung (RCD) zu schalten, sofern zuvor der funktionsfähige Schutzleiter (PE) erkannt wurde.

10. Verfahren nach einem der Ansprüche 7 bis 9,
**gekennzeichnet durch**
Erzeugen eines zweiten Steuersignals (S19b) an eine/die zweite elektronische Schalteinheit (P19) mittels der Systemsteuerung (P8) um einen/den künstlichen Auslösestrom (IA) zum Auslösen der Fehlerstrom-Schutzeinrichtung (RCD) zu schalten.

11. Verfahren nach einem der Ansprüche 7 bis 10,
**dadurch gekennzeichnet,**
**dass** im Fall einer 3-phasigen Zuleitung (L) getrennt für jeden der drei aktiven Phasenleiter (L1, L2, L3) ein künstlicher, passiver Fehlerstrom (IFa, IFb, IFc) geschaltet wird, wobei jedem der drei aktiven Phasenleiter (L1, L2, L3) in der ersten elektronischen Schalteinheit (P11) ein elektronischer Schalter (P11a, P11b, P11c) zugeordnet wird.

12. Verfahren nach Anspruch 11,
**gekennzeichnet durch**
Messen einer Netzfrequenz und/oder Erkennen einer Drehfeldrichtung in einer Messeinrichtung (P64) der RCMB-Steuerung (P6) mittels geeigneter Steuersignal-Muster (S11) auf den aktiven Phasenleitern (L1, L2, L3).

13. Verfahren nach einem der Ansprüche 7 bis 10,
**dadurch gekennzeichnet,**
**dass** im Fall einer 3-phasigen Zuleitung (L) für die drei aktiven Phasenleiter (L1, L2, L3) ein gemeinsamer, über den Schutzleiter fließender, künstlicher, passiver Fehlerstrom (IFd) mittels genau eines elektronischen Schalters (P11d) geschaltet wird.

## Claims

1. An electric circuit device (2) for detecting a closed switch contact (K) of a switching-off device (P4) as well as for recognizing a protective ground conductor interruption in a one- or multiphase electric supply line (L) having active conductors (L1, L2, L3, N) and a protective ground conductor (PE),
having a residual current monitoring module (RCMB) which comprises a RCMB control (P6) for evaluating a measuring signal supplied by a measuring current transformer (P9) and for generating a first switching-off signal (S4a), the measuring current transformer (P9) capturing a residual current flowing on the supply line (L), and having a system control (P8) for generating a second switching-off signal (S4b),
the switching-off device (P4) being configured for separating the active conductors (L1, L2, L3, N) and comprising a signal input (P41) for receiving the first switching-off signal (S4a) and the second switching-off signal (S4b), and the system control (P8) being connected to the RCMB control (P6) of the residual current monitoring module (RCMB) for receiving a fault signal (S8), **characterized in that**
the RCMB control (P6) comprises a fault current control unit (P61) for generating a control signal pattern (S11) which controls a first electronic switch unit (P11) for switching an artificial passive fault current (IF) flowing via one or more of the active conductors (L1, L2, L3, N) and the protective ground conductor (PE), the switched artificial passive fault current (IF) being settable such that it is detected as a residual current by the residual current monitoring module (RCMB) but does not trigger a fault current protective device (RCD) installed in the supply line (L),
the RCMB control (P6) comprising a signaling device (P63) which signals detecting the artificial passive fault current (IF) and thus the presence of the functional protective ground conductor (PE) as well as a mains voltage (UL1, UL2, UL3), and
the RCMB control (P6) comprises a fault current comparator (P62) which compares a fault current progression detected by the measuring current transformer (P9) to the fault current progression expected due to the control signal pattern (S11) in order to reliably detect the switched artificial passive fault current (IF).

2. The electric circuit device (2) according to claim 1,
**characterized in that**
the fault current control unit (P61) is configured for generating a first control signal (S19a) to a second electronic switch unit (P19) in order to switch an artificial trigger current (IA) for triggering the fault current protective device (RCD), provided that the functional protective ground conductor (PE) was recognized previously.

3. The electric circuit device (2) according to any one of the claims 1 or 2,
**characterized by**
the system control (P8) which is configured for generating a second control signal (S19b) to a/the second electronic switch unit (P19) in order to switch an/the artificial trigger current (IA) for triggering the fault current protective device (RCD).

4. The electric circuit device (2) according to any one of the claims 1 to 3,
**characterized in that**
the first electronic switch unit (P11) has three electronic switches (P11a, P11b, P11c) in the instance of a three-phase supply line (L), one electronic switch (P11a, P11b, Pile) being assigned to each active phase conductor (L1, L2, L3) in order to separately switch an artificial passive fault current (IFa, IFb, IFc) for each of the three active phase conductors (L1, L2, L3).

5. The electric circuit device (2) according to claim 4,
**characterized in that**
the RCMB control (P6) comprises a measuring device (P64) for measuring the mains frequency and/or for detecting the direction of a rotating magnetic field by means of suitable control signal patterns (S11) on the active phase conductors (L1, L2, L3).

6. The electric circuit device (2) according to any one of the claims 1 to 3,
**characterized in that**
the first electronic switch unit (P11) comprises an electronic switch (P11d) in the case of a three-phase supply line (L), the electronic switch (P11d) switching a common artificial passive fault current (IFd) for the three active phase conductors (L1, L2, L3).

7. A method for detecting a closed switch contact (K) of a switching-off device (P4) as well as for recognizing a protective ground conductor interruption in a one- or multiphase electric supply line (L) having active conductors (L1, L2, L3, N) and a protective ground conductor (PE),
the supply line being equipped with a residual current monitoring module (RCMB) which comprises a RCMB control (P6) for evaluating a measuring signal supplied by a measuring current transformer (P9) and for generating a first switching-off signal (S4a), the measuring current transformer (P9) capturing a residual current flowing on the supply line (L), and the supply line being equipped with the switching-off device (P4) for separating the active conductors (L1, L2, L3, N) and with a system control (P8) for generating a second switching-off signal (S4b),
comprising the method steps:
- generating a control signal pattern (S11) in a fault current control unit (P61) of the RCMB control (P6),
- controlling a first electronic switch unit (P11) using the control signal pattern (S11) for switching an artificial passive fault current (IF) which flows via one or more of the active conductors (L1, L2, L3, N) and the protective ground conductor (PE),
- setting the switched artificial passive fault current (IF) such that it is detected as a residual current by the residual current monitoring module (RCMB) but does not trigger a fault current protective device installed in the supply line (L),
- signaling a detected artificial passive fault current (IF),
- comparing a fault current progression detected by the measuring current transformer (P9) to the fault current progression expected due to the control signal pattern (S11) by means of a fault current comparator (P62) in the RCMB control (P6) in order to reliably detect the switched artificial passive fault current (IF).

8. The method according to claim 7,
**characterized by**
separating the active conductors (L1, L2, L3, N) by means of the switching-off device (P4) via the first switching-off signal (S4a) or the second switching-off signal (S4b) if the artificial passive fault current (IF) is signaled.

9. The method according to claim 7 or 8,
**characterized by**
generating a first control signal (S19a) to a second electronic switch unit (P19) by means of the fault current control unit (P61) in order to switch an artificial trigger current (IA) for triggering the fault current protective device (RCD), provided that the functioning protective ground conductor was recognized previously.

10. The method according to any one of the claims 7 to 9,
**characterized by**
generating a second control signal (S19b) to a/the second electronic switch unit (P19) by means of the system control (P8) in order to switch an/the artificial trigger current (IA) for triggering the fault current protective device (RCD).

11. The method according to any one of the claims 7 to 10,
**characterized in that**
in the case of a three-phase supply line (L), an artificial passive fault current (IFa, IFb, IFc) is switched separately for each of the three active phase conductors (L1, L2, L3), one electronic switch (P11a, P11b, Pile) being assigned to each active phase conductor (L1, L2, L3) in the first electronic switch unit (P11).

12. The method according to claim 11,
**characterized by**
measuring a mains frequency and/or detecting a direction of a rotating magnetic field in a measuring device (P64) of the RCMB control (P6) by means of suitable control signal patterns (S11) on the active phase conductors (L1, L2, L3).

13. The method according to any one of the claims 7 to 10,
**characterized in that**
in the event of a three-phase supply line (L) a shared artificial passive fault current (IFd) flowing via the protective conductor is switched for the three active phase conductors (L1, L2, L3) by means of exactly one electronic switch (P11d).

## Revendications

1. Dispositif de circuit (2) électrique pour la détection d'un contact commutateur (K) fermé d'un dispositif de déconnexion (P4) ainsi que pour l'identification d'une coupure du fil de protection dans une alimentation (L) électrique monophasée ou multiphasée ayant des conducteurs (L1, L2, L3, N) actifs et un fil de protection (PE), le dispositif de circuit (2) ayant un module (RCMB) de surveillance à courant différentiel résiduel qui comprend un contrôleur de RCMB (P6) pour l'évaluation d'un signal de mesure alimenté par un transformateur (P9) de courant de mesure et pour la génération d'un premier signal de déconnexion (S4a), le transformateur (P9) de courant de mesure enregistrant un courant différentiel résiduel écoulant sur l'alimentation (L),
et le dispositif de circuit (2) ayant un contrôle de commande (P8) pour la génération d'un deuxième signal de déconnexion (S4b), le dispositif de déconnexion (P4) étant configuré pour la coupure de conducteurs (L1, L2, L3, N) actifs et comprenant une entrée de signal (P41) pour la réception du premier signal de déconnexion (S4a) et du deuxième signal de déconnexion (S4b), et le contrôle de commande (P8) étant relié au contrôleur de RCMB (P6) du module (RCMB) de surveillance à courant différentiel résiduel pour la réception d'un signal de faute (S8),
**caractérisé en ce que**
le contrôleur de RCMB (P6) comprend une unité (P61) de contrôle à courant de faute pour la génération d'un modèle (S 11) de signal de contrôle qui contrôle une première unité commutatrice (P11) électronique pour la commutation d'un courant de faute (IF) artificiel passif écoulant par un ou plusieurs conducteurs (L1, L2, L3, N) actifs et par le fil de protection (PE),
le courant de faute (IF) commuté artificiel passif pouvant être ajusté de telle manière qu'il est détecté comme courant différentiel résiduel par le module (RCMB) de surveillance à courant différentiel résiduel mais il ne provoque pas une réponse d'un dispositif (RCD) de protection à courant différentiel résiduel installé dans l'alimentation (L),
le contrôleur de RCMB (P6) comprenant un dispositif de signalisation (P63) qui signale une détection du courant de faute (IF) artificiel passif et donc la présence d'un fil de protection (PE) opérationnel ainsi que d'une tension d'alimentation (UL1, UL2, UL3), et
le contrôleur de RCMB (P6) comprend un comparateur (P62) à courant de faute qui compare une courbe de courant de faute détectée par le transformateur (P9) de courant de mesure à la courbe de courant de faute attendue en raison du modèle (S11) de signal de contrôle afin de détecter sérieusement le courant de faute (IF) commuté artificiel passif.

2. Dispositif de circuit (2) électrique selon la revendication 1,
**caractérisé en ce que**
l'unité (P61) de contrôle à courant de faute est configurée pour la génération d'un premier signal de contrôle (S19a) à une deuxième unité commutatrice (P19) électronique afin de commuter un courant conventionnel de déclenchement (IA) artificiel pour le déclenchement du dispositif (RCD) de protection à courant différentiel résiduel, à condition que le fil de protection (PE) opérationnel ait été identifié au préalable.

3. Dispositif de circuit (2) électrique selon l'une quelconque des revendications 1 ou la revendication 2,
**caractérisé par**
le contrôle de commande (P8) qui est configuré pour la génération d'un deuxième signal de contrôle (S19b) à un/au deuxième unité commutatrice (P19) électronique afin de commuter un/le courant conventionnel de déclenchement (IA) artificiel pour le déclenchement du dispositif (RCD) de protection à courant différentiel résiduel.

4. Dispositif de circuit (2) électrique selon l'une quelconque des revendications 1 à 3,
**caractérisé en ce que**
la première unité commutatrice (P11) électronique a trois commutateurs (P11a, P11b, Plie) électroniques dans le cas d'une alimentation (L) triphasée, un commutateur (P11a, P11b, Plie) électronique étant assigné à chacun des trois conducteurs de phase (L1, L2, L3) actifs afin de commuter séparément un courant de faute (IFa, IFb, IFc) artificiel passif pour chacun des trois conducteurs de phase (L1, L2, L3) actifs.

5. Dispositif de circuit (2) électrique selon la revendication 4,
**caractérisé en ce que**
le contrôleur de RCMB (P6) comprend un dispositif de mesure (P64) pour la mesure de la fréquence industrielle et/ou pour la détection du sens d'un champ magnétique tournant au moyen de modèles (S11) de signal de contrôle appropriés sur les conducteurs de phase (L1, L2, L3) actifs.

6. Dispositif de circuit (2) électrique selon l'une quelconque des revendications 1 à 3,
**caractérisé en ce que**
la première unité commutatrice (P11) électronique comprend un commutateur (P11d) électronique dans le cas d'une alimentation (L) triphasée, le commutateur (P11d) électronique commutant un courant de faute (IFd) commun artificiel passif pour les trois conducteurs de phase (L1, L2, L3) actifs.

7. Procédé pour la détection d'un contact commutateur (K) fermé d'un dispositif de déconnexion (P4) ainsi que pour l'identification d'une coupure du fil de protection dans une alimentation (L) électrique monophasée ou multiphasée ayant des conducteurs (L1, L2, L3, N) actifs et un fil de protection (PE),
l'alimentation étant équipée d'un module (RCMB) de surveillance à courant différentiel résiduel qui comprend un contrôleur de RCMB (P6) pour l'évaluation d'un signal de mesure alimenté par un transformateur (P9) de courant de mesure et pour la génération d'un premier signal de déconnexion (S4a), le transformateur (P9) de courant de mesure enregistrant un courant différentiel résiduel écoulant sur l'alimentation (L), et l'alimentation étant équipée du dispositif de déconnexion (P4) pour la coupure des conducteurs actifs (L1, L2, L3, N) et d'un contrôle de commande (P8) pour la génération d'un deuxième signal de déconnexion (S4b),
comprenant les étapes de procédé suivantes :
- une étape de génération d'un modèle (S 11) de signal de contrôle dans une unité (P61) de contrôle à courant de faute du contrôleur de RCMB (P6),
- une étape de contrôle d'une première unité commutatrice (P11) électronique en utilisant le modèle (S 11) de signal de contrôle pour la commutation d'un courant de faute (IF) artificiel passif qui écoule par un ou plusieurs conducteurs (L1, L2, L3, N) actifs et par le fil de protection (PE),
- une étape d'ajustement du courant de faute (IF) commuté artificiel passif de telle manière qu'il est détecté comme courant différentiel résiduel par le module (RCMB) de surveillance à courant différentiel résiduel mais il ne provoque pas une réponse d'un dispositif (RCD) de protection à courant différentiel résiduel installé dans l'alimentation (L),
- une étape de signalisation d'un courant de faute (IF) détecté artificiel passif,
- une étape de comparaison d'une courbe de courant de faute détectée par le transformateur (P9) de courant de mesure à la courbe de courant de faute attendue en raison du modèle (S11) de signal de contrôle au moyen d'un comparateur (P62) à courant de faute dans le contrôleur de RCMB (P6) afin de détecter sérieusement le courant de faute (IF) commuté artificiel passif.

8. Procédé selon la revendication 7,
**caractérisé par**
une étape de coupure de conducteurs (L1, L2, L3, N) actifs au moyen du dispositif de déconnexion (P4) par le premier signal de déconnexion (S4a) ou par le deuxième signal de déconnexion (S4b) au cas où le courant de faute (IF) artificiel passif serait été signalé.

9. Procédé selon la revendication 7 ou la revendication 8,
**caractérisé par**
une étape de génération d'un premier signal de contrôle (S19a) à une deuxième unité commutatrice (P19) électronique au moyen de l'unité (P61) de contrôle à courant de faute afin de commuter un courant conventionnel de déclenchement (IA) artificiel pour le déclenchement du dispositif (RCD) de protection à courant différentiel résiduel, à condition que le fil de protection opérationnel ait été identifié au préalable.

10. Procédé selon l'une quelconque des revendications 7 à 9,
**caractérisé par**
une étape de génération d'un deuxième signal de contrôle (S19b) à une/à la deuxième unité commutatrice (P19) électronique au moyen du contrôle de commande (P8) afin de commuter un/le courant conventionnel de déclenchement (IA) artificiel pour le déclenchement du dispositif (RCD) de protection à courant différentiel résiduel.

11. Procédé selon l'une quelconque des revendications 7 à 10,
**caractérisé en ce que**
dans le cas d'une alimentation (L) triphasée, un courant de faute (IFa, IFb, IFc) artificiel passif est commuté séparément pour chacun des trois conducteurs de phase (L1, L2, L3) actifs, un commutateur (P11a, P11b, Plie) électronique étant assigné à chacun des trois conducteurs de phase (L1, L2, L3) actifs dans la première unité commutatrice (P11) électronique.

12. Procédé selon la revendication 11,
**caractérisé par**
une étape de mesure d'une fréquence industrielle et/ou une étape de détection d'un sens d'un champ magnétique tournant dans un dispositif de mesure (P64) du contrôleur de RCMB (P6) au moyen de modèles (S11) de signal de contrôle appropriés sur les conducteurs de phase (L1, L2, L3) actifs.

13. Procédé selon l'une quelconque des revendications 7 à 10,
**caractérisé en ce que**
dans le cas d'une alimentation (L) triphasée, un courant de faute (IFd) commun artificiel passif écoulant par le fil de protection est commuté pour les trois conducteurs de phase (L1, L2, L3) actifs au moyen d'exactement un commutateur (P11d) électronique.
